(19) Europäisches Patentamt

European Patent Office

Office européen des brevets

(11) **EP 1 520 299 B1**

(12) **EUROPÄISCHE PATENTSCHRIFT**

(45) Veröffentlichungstag und Bekanntmachung des Hinweises auf die Patenterteilung:
**25.10.2006 Patentblatt 2006/43**

(21) Anmeldenummer: **03762398.0**

(22) Anmeldetag: **12.06.2003**

(51) Int Cl.:
**H01L 27/08** (2006.01)

(86) Internationale Anmeldenummer:
**PCT/DE2003/001956**

(87) Internationale Veröffentlichungsnummer:
**WO 2004/006334 (15.01.2004 Gazette 2004/03)**

(54) **SATZ INTEGRIERTER KONDENSATORANORDNUNGEN, INSBESONDERE INTEGRIERTER GITTERKONDENSATOREN**

SET OF INTEGRATED CAPACITOR ARRANGEMENTS, ESPECIALLY INTEGRATED GRID CAPACITORS

ENSEMBLE D'AGENCEMENTS DE CONDENSATEURS INTEGRES, EN PARTICULIER DE CONDENSATEURS DE GRILLE INTEGRES

(84) Benannte Vertragsstaaten:
**DE FR**

(30) Priorität: **08.07.2002 DE 10230697**

(43) Veröffentlichungstag der Anmeldung:
**06.04.2005 Patentblatt 2005/14**

(60) Teilanmeldung:
**05106669.4 / 1 587 145**

(73) Patentinhaber: **Infineon Technologies AG**
**81669 München (DE)**

(72) Erfinder:
• **FISCHER, Armin**
 **81825 München (DE)**
• **UNGAR, Franz**
 **85232 Unterbachern (DE)**

(74) Vertreter: **Kindermann, Peter et al**
**Kindermann Patentanwälte**
**Postfach 10 02 34**
**85593 Baldham (DE)**

(56) Entgegenhaltungen:
**WO-A-01/93283     DE-A- 3 124 740**
**US-A- 4 190 854     US-B1- 6 198 619**

• **PATENT ABSTRACTS OF JAPAN vol. 2000, no. 14, 5. März 2001 (2001-03-05) -& JP 2000 323664 A (NEC CORP), 24. November 2000 (2000-11-24) -& US 6 417 557 B1 (HARUKI TADASHI) 9. Juli 2002 (2002-07-09)**
• **PATENT ABSTRACTS OF JAPAN vol. 1999, no. 02, 26. Februar 1999 (1999-02-26) -& JP 10 303061 A (MATSUSHITA ELECTRIC IND CO LTD), 13. November 1998 (1998-11-13)**
• **PATENT ABSTRACTS OF JAPAN vol. 009, no. 277 (E-355), 6. November 1985 (1985-11-06) -& JP 60 121757 A (NIPPON DENKI KK), 29. Juni 1985 (1985-06-29)**

**Beschreibung**

Satz integrierter Kondensatoranordnungen, insbesondere integrierter Gitterkondensatoren

Die Erfindung betrifft eine integrierte Kondensatoranordnung, die mindestens einen schaltungstechnisch wirksamen Hauptkondensator enthält.

Aus einer integrierten Anordnung lassen sich einzelne Bauelemente mechanisch nicht ohne Zerstörung der Bauelemente voneinander trennen. Als Herstellungstechniken für integrierte Anordnungen werden unter anderem Schichtaufbringungsverfahren und Schichtstrukturierungsverfahren eingesetzt.

Ein Kondensator enthält zwei einander gegenüberliegende Elektroden, zwischen denen ein Dielektrikum angeordnet ist. Beispiele für integrierte Kondensatoren sind:

-  sogenannte MIM-Kondensatoren (Metall Isolator Metall),
-  gestapelte Kondensatoren, die auch als Sand(wich)-Kondensatoren bezeichnet werden, oder
-  Gitterkondensatoren, die auch als Grid-Kondensatoren bezeichnet werden.

Eine Kapazität ist schaltungstechnisch wirksam, wenn sie nicht nur parasitär, d.h. eigentlich unerwünscht ist, sondern auch für das Funktionieren der Schaltungsanordnung erforderlich ist. Beispielsweise dienen schaltungstechnisch wirksame Kondensatoren als:

-  Block- oder Stützkondensator,
-  Teil eines Schwingkreises,
-  Ladekondensator, oder
-  zum Speichern von digitalen Informationen.

Bei der Herstellung von sogenannten BEOL-Kapazitäten (Back End Of Line) oder von Far-BEOL-Kapazität in integrierter Form kommt es zu erheblichen Streuungen der Kapazitätswerte. Die Streuung entsteht durch Geometrieabweichungen infolge von Prozessinhomogenitäten. Die Streuungen treten innerhalb einer Halbleiterscheibe bzw. eines Wafers, innerhalb eines Fertigungsloses sowie auch zwischen verschiedenen Fertigungslosen auf. Liegt der Kapazitätswert eines Kondensators außerhalb der vorgegebenen Spezifikationsgrenzen, so kommt es zu einem sogenannten Performance-Verlust oder sogar zu einem Ausbeuteverlust des entsprechenden integrierten Schaltkreises.

Die JP 20003 23664 zeigt einen Halbleiterschaltkreis bei dem Maskenmuster verändert werden, um eine Kapazität einzustellen. Die US 6,198,619 B1 betrifft eine Leiterplatte bei der Kupferfolien mit einer Nadel durchstochen werden, um eine elektrisch leitfähige Verbindung herzustellen und um die Kapazität von Kondensatoren zu beeinflussen. Die JP 10 303061 erläutert Korrekturmöglichkeiten in zwei Richtungen. Als Anwendung wird angegeben, dass es nun möglich sein soll Fehlkorrekturen zu korrigieren, so dass die Geschwindigkeit der Korrektur erhöht werden kann. Aus den Dokumenten US 4190 854 sowie JP 60 121 757 sind weitere kalibrierbare Kondensatoranordnungen bekannt.

Es ist Aufgabe der Erfindung, einen einfach herzustellenden Satz von Kondensatoranordnungen anzugeben, deren Kapazität möglichst nahe an einer vorgegebenen Sollkapazität liegt. Insbesondere soll ein Satz von Gitterkondensatoren angegeben werden.

Diese Aufgabe wird durch einen Satz von Kondensatoranordnungen mit den im Patentanspruch 1 angegebenen Merkmalen gelöst. Weiterbildungen sind in den Unteransprüchen angegeben.

Der erfindungsgemäße Satz enthält mindestens zwei integrierten Kondensatoranordnungen, die gemäß gleichen geometrischen Entwürfen bzw. Layouts hergestellt worden sind und die jeweils einen schaltungstechnisch wirksamen Hauptkondensator und mindestens einen Korrekturkondensator enthalten. Die eine Kondensatoranordnung enthält eine elektrisch leitfähige Verbindung zwischen dem Korrekturkondensator und dem Hauptkondensator, wobei die Verbindung nach der Herstellung des Hauptkondensators dieser Kondensatoranordnung hergestellt worden ist. Die andere Kondensatoranordnung enthält eine elektrisch isolierenden Unterbrechung zwischen dem gleichen Korrekturkondensator und dem Hauptkondensator, wobei die Unterbrechung gemäß den geometrischen Entwürfen hergestellt worden ist.

Müssen Korrekturen beispielsweise nur bei 20 Prozent der hergestellten Kondensatoranordnungen durchgeführt werden, um die Sollkapazität zu erreichen, so sinkt der Aufwand erheblich im Vergleich zu einer Korrekturmöglichkeit, bei der die Korrektur nur durch Abtrennen von Kondensatoren ausgeführt werden kann. Bei einer solchen Korrektur wären nämlich in 80 Prozent der Kondensatoranordnungen Kondensatoren lokal abzutrennen.

Die Verbindung wird bei einer Weiterbildung auf einfache Art durch lokales Erhitzen hergestellt, so dass Bauelemente in der Umgebung der Verbindung vor einer erhöhten Wärmebelastung geschützt sind. Außerdem lassen sich durch lokales Erhitzen auf einfache Art dauerhafte Verknüpfungen herstellen. Im Vergleich zum Herstellen von Unterbrechungen durch lokales Erhitzen können Verknüpfungen durch lokales Erhitzen bei niedrigeren Temperaturen durchgeführt werden. Damit ist die thermische Belastung insbesondere bei der Herstellung einer Vielzahl von Verknüpfungen auf einer Halbleiterscheibe gering.

Das lokale Erhitzen wird beispielsweise mit Hilfe eines Laserstrahls durchgeführt. Damit ist eine Möglichkeit gegeben, die Kapazität des schaltungstechnisch wirksamen Hauptkondensators durch eine Parallel- oder Serienschaltung mit dem Korrekturkondensatoren zu vergrößern bzw. zu verkleinern. Diese Korrekturmöglichkeit gestattet es, integrierte Kondensatoranordnungen mit vorgegebenen Kapazitätswerten auf einfache Art zu produzieren.

Bei einer Weiterbildung enthält die Verbindung zwei zueinander beabstandete Leitbahnabschnitte, zwischen denen nur ein Dielektrikum angeordnet ist. Die Materialien der Leitbahnabschnitte und des Dielektrikums sind so gewählt, dass beim Erhitzen Materialverwerfungen der Leitbahn entstehen, die das Dielektrikum durchdringen. Beispielsweise lässt sich hier das sonst unerwünschte "Spiking" zum Herstellen einer elektrischen Verbindung nutzen. Bei einer alternativen Ausgestaltung enthält das Dielektrikum Dotieratome, die beim Erhitzen die Leitfähigkeit des Dielektrikums ändern. In diesem Zusammenhang wird auch von einem Aktivieren der Dotieratome gesprochen. Jedoch gibt es auch noch andere Möglichkeiten zur Herstellung der Verbindung, die auch als Antifuse bezeichnet wird.

Bei einer nächsten Weiterbildung enthalten die Schaltungsanordnungen mindestens einen weiteren Korrekturkondensator, der vom Hauptkondensator abgetrennt ist oder zum Hauptkondensator zugeschaltet worden ist.

Die Weiterbildung geht von der Überlegung aus, dass die Kapazitätswerte von eigentlich gleich aufzubauenden integrierten Kondensatoren um einen Sollwert sowohl nach unten als auch nach oben streuen. Korrekturen können auf ein Minimum beschränkt werden, wenn es sowohl eine Korrekturmöglichkeit des Kapazitätswertes zu größeren Kapazitätswerten hin als auch eine Korrekturmöglichkeit zu kleineren Kapazitätswerten hingibt. Der weitere Korrekturkondensator bietet im Vergleich zu dem oben genannten Korrekturkondensator bei Parallelschaltung der Kondensatoren diese zweite Korrekturmöglichkeit.

Bei einer Weiterbildung wird eine weitere Unterbrechung zum Abtrennen des weiteren Korrekturkondensators durch lokales Erhitzen hergestellt. Das lokale Erhitzen lässt sich beispielsweise mit Hilfe eines Laserstrahls oder mit Hilfe eines Stromstoßes durch eine Leitbahneinengung durchführen.

Bei einer anderen Weiterbildung werden Dielektrika der Kondensatoren durch ein Dielektrikum zwischen Metallisierungslagen gebildet, in denen Verbindungsabschnitte von Verbindungen zu integrierten Halbleiterbauelementen der integrierten Kondensatoranordnung liegen. Im Bereich des Kondensators lässt sich ein anderes Dielektrikum verwenden als im übrigen Bereich zwischen den Metallisierungslagen, z.B. ein Dielektrikum mit einer höheren Dielektrizitätskonstante. Beispiele für solche Kondensatoren sind gestapelte Kondensatoren oder Gitterkondensatoren. Mit anderen Worten liegen die Elektroden eines Kondensators in mehr als zwei Metallisierungslagen. Bei solchen Kondensatoren werden bei einer Ausgestaltung nicht nur Elektroden in der obersten Metallisierungslage sondern auch Elektroden in unteren Metallisierungslagen bei der Korrektur schaltungstechnisch abgetrennt oder schaltungstechnisch hinzugefügt. Die Verknüpfungselemente und Unterbrechungen für die unteren Elektroden liegen entweder in der unteren Metallisierungslage, so dass bspw. entsprechend tiefe Aussparungen für einen Laserstrahl vorzusehen sind, oder in einer oberen Metallisierungslage, zu der Verbindungen von der unteren Metallisierungslage führen.

Bei einer anderen Weiterbildung haben Dielektrika der Kondensatoren eine Dicke, die wesentlich kleiner als die Dicke des Dielektrikums zwischen Metallisierungslagen ist. Beispiele für solche Kondensatoren sind MIM-Kondensatoren. Mit anderen Worten liegt mindestens eine Elektrode des Kondensators außerhalb einer Metallisierungslage.

Bei einer nächsten Weiterbildung beträgt die Kapazität eines Korrekturkondensators weniger als 1/3, weniger als 1/10, weniger als 1/100 oder weniger als 1/1000 der Kapazität eines Hauptkondensators. Durch diese Maßnahme wird erreicht, dass eine Feintrimmung möglich ist. So lassen sich mit Korrekturmöglichkeiten im Promille-Bereich die Kapazitätswerte zweier Kondensatoranordnungen derselben integrierten Schaltungsanordnung sehr genau aufeinander abstimmen. Dies ist für einige Anwendungsfälle zwingend erforderlich.

Die Erfindung betrifft außerdem einen Satz Gitterkondensatoren mit Korrekturquerelektroden. Auch einzelne Querelektroden der Gitterkondensatoren bieten eine Möglichkeit für eine Korrektur der Kapazität bei der Herstellung. Die oben genannten technischen Wirkungen gelten deshalb insbesondere für die Gitterkondensatoren.

Im Folgenden werden Ausführungsbeispiele der Erfindung an Hand der beiliegenden Zeichnungen erläutert. Darin zeigen:

Figur 1    eine Draufsicht auf eine MIM-Kondensatoranordnung,

Figur 2    eine Draufsicht auf eine Gitterkondensatoranordnung,

Figur 3    eine Querelektrode eines Gitterkondensators mit zwei Unterbrechungsmöglichkeiten,

Figur 4    eine Querelektrode eines Gitterkondensators mit einer kontinuierlichen Unterbrechungsmöglichkeit, und

Figur 5    Verfahrensschritte zum Korrigieren der Kapazität eines integrierten Kondensators.

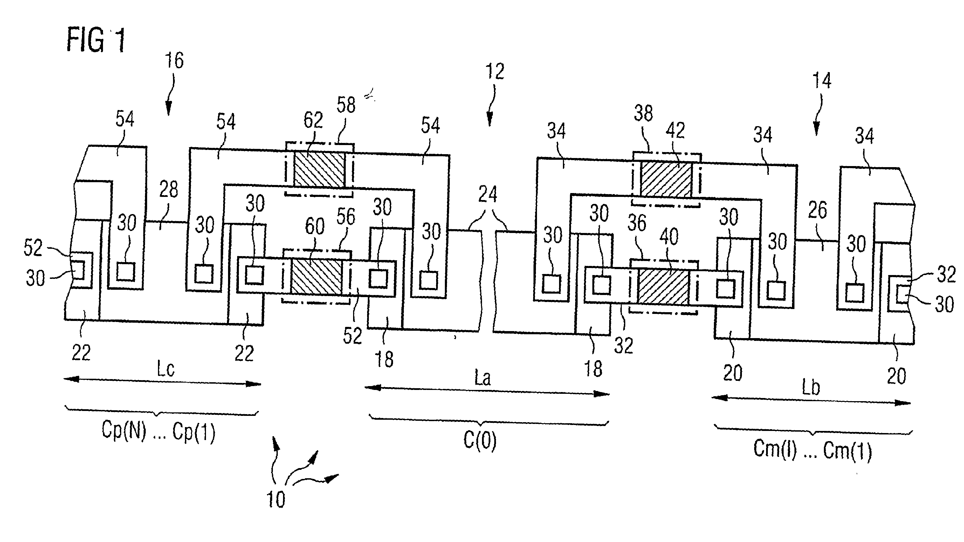

Figur 1 zeigt eine Draufsicht auf eine MIM-Kondensatoranordnung 10, die einen mit einer elektronischen Schaltung verbundenen Hauptkondensator 12 und mehrere rechts vom Hauptkondensator 12 liegende abtrennbare Kondensatoren enthält, von denen nur ein abtrennbarer Kondensator 14 dargestellt ist. Das Dielektrikum ist in Figur 1 aus Gründen der besseren Übersichtlichkeit nicht dargestellt.

In der Kondensatoranordnung 10 liegen links vom Hauptkondensator 12 mehrere zuschaltbare Kondensatoren, von denen in Figur 1 ein zuschaltbarer Kondensator 16 dargestellt ist. Die Kondensatoren 12 bis 16 sind bis auf ihre Längsabmessungen gleich aufgebaut. Die Kondensatoren 12, 14 und 16 enthalten jeweils eine substratnahe Bodenelektrode 18, 20 bzw. 22 und eine substratferne Elektrode 24, 26 bzw. 28. Die Bodenelektroden 18, 20 bzw. 22 sind länger als die jeweils zugehörige substratferne Elektrode 24, 26 bzw. 28 und ragen in Längsrichtung beidseitig über die substratferne Elektrode 24, 26 bzw. 28 hinaus, so dass an den substratnahen Bodenelektroden 18, 20 bzw. 22 Anschlussbereiche für vertikal verlaufende Kontakte 30 entstehen.

Der Hauptkondensator 12 und die abtrennbaren Kondensatoren 16 sind durch Leitbahnen 32 zwischen den Bodenelektroden 18, 20 und durch Leitbahnen 34 zwischen den substratfernen Elektroden 24, 26 elektrisch parallel geschaltet. Geometrisch gesehen sind die abtrennbaren Kondensatoren 14 aber in einer Reihe hintereinander angeordnet. Die Leitbahnen 32 und 34 liegen in einer oberen Metallisierungslage. Zu jeder Leitbahn 32 bzw. 34 führt eine Aussparung 36 bzw. 38 in einem nicht dargestellten Isoliermaterial, das die Leitbahnen 32 und 34 bedeckt. Durch die Aussparungen 36 bzw. 38 lassen sich bei einer Korrektur der Kapazität des Hauptkondensators 12 Bereiche 40 bzw. 42 einer Leitbahn 32 bzw. 34 mit Hilfe eines Laserstrahls verdampfen, so dass eine Unterbrechung entsteht.

Andererseits sind die zuschaltbaren Kondensatoren 16 mit Hilfe von Leiterbahnen 52 zwischen den Bodenelektroden 18, 22 bzw. Leitbahnen 54 zwischen den substratfernen Elektroden 24, 28 zum Hauptkondensator 12 elektrisch parallel schaltbar. Geometrisch sind die zuschaltbaren Kondensatoren 16 aber in einer Reihe angeordnet. Auch die Leitbahnen 52 und 54 liegen in einer oberen Metallisierungslage.

Aussparungen 56 bzw. 58 führen durch ein nicht dargestelltes Isoliermaterial bis zu Verknüpfungsbereichen 60 bzw. 62 der Leitbahnen 52 bzw. 54. Die Verknüpfungsbereiche 60, 62 bilden sogenannte Antifuses, d.h. eine Verbindungsmöglichkeit, die beim Auftreffen eines Laserstrahls eine dauerhafte elektrisch leitende Verbindung zwischen den Abschnitten der Leitbahn 52 bzw. einer Leitbahn 54 bildet.

Der Hauptkondensator 12 hat in Längsrichtung der Kondensatoranordnung 10 eine Länge La, die größer als Längen Lb der abtrennbaren Kondensatoren 14 bzw. als Längen Lc der zuschaltbaren Kondensatoren 16 ist. Damit ist auch eine Kapazität C(0) des Hauptkondensators 12 größer als eine Kapazität Cm(I) des Kondensators 14. Dabei ist I eine natürliche Zahl zur Bezeichnung des letzten abtrennbaren Kondensators 14. Die nicht dargestellten abtrennbaren Kondensatoren haben Kapazitäten Cm(1) bis Cm(I-1), die im erläuterten Ausführungsbeispiel gleich der Kapazität Cm (I) sind.

Die Kapazität C(0) des Hauptkondensators 12 ist ebenfalls größer als die Kapazität Cp(1) des zuschaltbaren Kondensators 16. Die in Figur 1 nicht dargestellten zuschaltbaren Kondensatoren haben Kapazitäten Cp(2) bis Cp(N), die gleich der Kapazität Cp(1) bzw. Cm(I) sind. Dabei ist N eine natürliche Zahl zur Bezeichnung des letzten zuschaltbaren Kondensators.

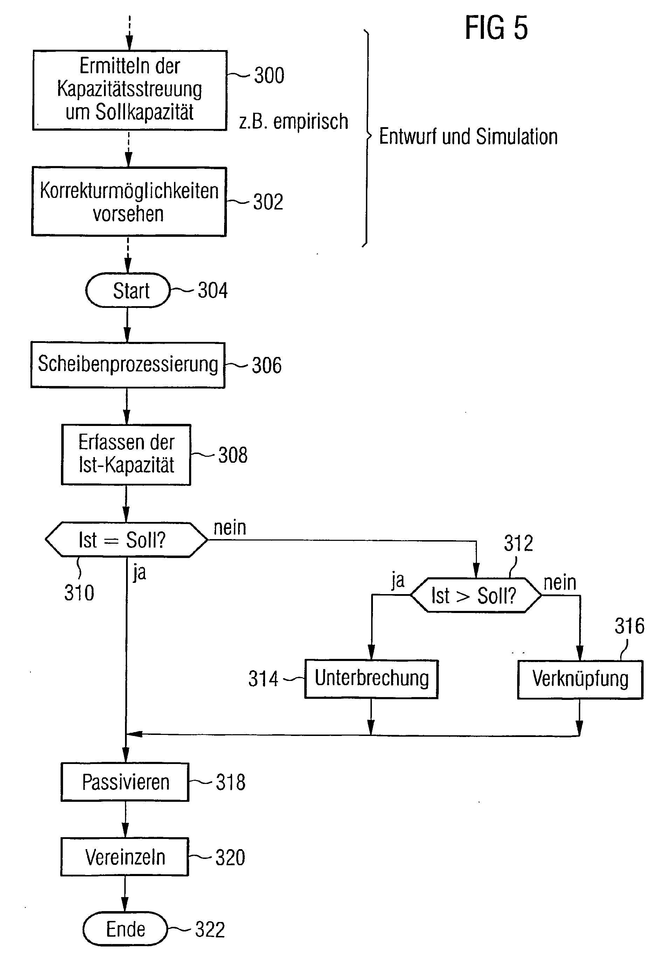

Die Korrektur der Kapazität der Kondensatoranordnung 10 wird unten an Hand der Figur 5 näher erläutert.

Bei einem anderen Ausführungsbeispiel gibt es rechts bzw. links des Hauptkondensators 12 nur einen abtrennbaren Kondensator 14 bzw. einen zuschaltbaren Kondensator 16. Bei einem nächsten Ausführungsbeispiel gibt es neben dem Hauptkondensator 12 nur einen oder mehrere zuschaltbare Kondensatoren 16 bzw. nur einen oder mehrere abschaltbare Kondensatoren 14. Bei einem nächsten Ausführungsbeispiel sind die Kapazitäten Cm(1) bis Cm (I) der Kondensatoranordnung 10 voneinander verschieden. Auch die Kapazitäten Cp(1) bis Cp(N) der Kondensatoranordnung 10 lassen sich voneinander verschieden ausbilden.

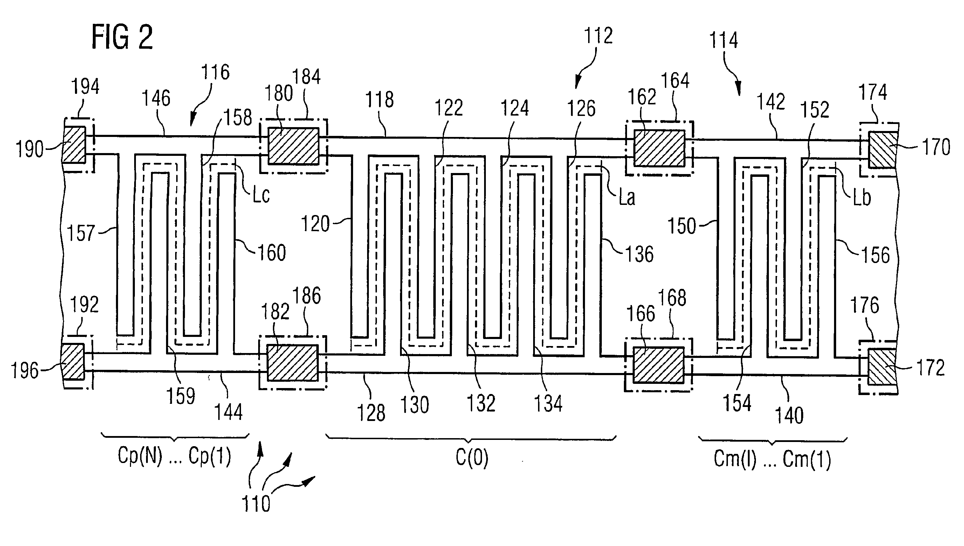

Figur 2 zeigt eine Draufsicht auf eine Gitterkondensatoranordnung 110, die einen mit einer Schaltung verbundenen Hauptkondensator 112 und mehrere abtrennbare Kondensatoren enthält, von denen in Figur 2 ein Kondensator 114 dargestellt ist. Weiterhin enthält die Gitterkondensatoranordnung 110 mehrere zuschaltbare Kondensatoren, von denen in Figur 2 ein Kondensator 116 dargestellt ist. In Figur 2 werden nur die obere Elektrode des Hauptkondensators 112, bzw. des Kondensators 114 bzw. des Kondensators 116 dargestellt. In den darunter liegenden Metallisierungslagen gibt es weitere Elektroden, die den gleichen Verlauf wie die oberen Elektroden haben. Bei einem ersten Ausführungsbeispiel sind die in den verschiedenen Metallisierungslagen liegenden Elektroden eines Kondensators 112, 114 bzw. 116 untereinander jeweils durch mindestens einen vertikalen Kontakt verbunden. Leitbahnen zwischen Kondensatoren 112, 114 und 116 liegen nur in der oberen Metallisierungslage.

Der Hauptkondensator 112 enthält in der oberen Metallisierungslage zwei kammförmige Elektroden, deren Zinken ineinander greifen. Von einer Längselektrode 118 zweigen bspw. vier Querelektroden 120 bis 126 ab, die in einem gleichbleibenden Rastermaß aufgereiht sind. An einer der Längselektrode 118 gegenüberliegenden Längselektrode 128 sind quer zur Längselektrode 128 genau so viele Querelektroden 130 bis 136 wie an der Längselektrode 118, d.h. vier Querelektroden 130 bis 136, angeordnet, die sich in die Zwischenräume zwischen den Querelektroden 120 bis 126 erstrecken. Damit wird zwischen den Querelektroden 120 bis 126 und 130 bis 136 ein mäanderförmig verlaufender Zwischenraum gebildet, der von einem Dielektrikum gefüllt ist. Die Länge des Mäanders des Hauptkondensators 112 sei wiederum La.

Die abtrennbaren Kondensatoren bzw. die zuschaltbaren Kondensatoren sind wie der Hauptkondensator 112 aufgebaut, enthalten jedoch kürzere Längselektroden 140, 142, 144 bzw. 146, von denen jeweils bspw. nur zwei Querelektroden 150 bis 160 abzweigen.

Zwischen der Längselektrode 118 und der Längselektrode 142 des Kondensators 114 liegt ein Bereich 162, zu dem eine Aussparung 164 von der Oberfläche des integrierten Schaltkreises führt. Zwischen der Längselektrode 128 und der Längselektrode 140 des Kondensators 114 liegt ein Bereich 166, zu dem eine weitere Aussparung 168 führt. Durch die Aussparungen 164 und 168 hindurch kann mit Hilfe eines Laserstrahls eine Unterbrechung zwischen den Längselektroden 118 und 142 bzw. den Längselektroden 128 und 140 in dem Bereich 162 bzw. 166 erzeugt werden. Dadurch lassen sich sämtliche abschaltbare Kondensatoren 114 vom Hauptkondensator 112 abtrennen. Zwischen den weiteren abschaltbaren Kondensatoren befinden sich weitere Bereiche 170 und 172, zu denen Aussparungen 174 und 176 führen, so dass auch an anderen Stellen abgetrennt werden kann.

Zwischen der Längselektrode 118 und der Längselektrode 146 des Korrektur-Kondensators 116 befindet sich ein Verknüpfungsbereich 180. Zwischen der Längselektrode 128 und der Längselektrode 144 des Kondensators 116 befindet sich ein Verknüpfungsbereich 182. Zum Verknüpfungsbereich 140 bzw. zum Verknüpfungsbereich 182 führt eine Aussparung 184 bzw. 186. Durch die Aussparungen 184 bzw. 186 lassen sich die Verknüpfungsbereiche 180 und 182 mit Hilfe eines Laserstrahls lokal erhitzen. Beim lokalen Erhitzen wird eine Verbindung zwischen der Längselektrode 118 und der Längselektrode 146 bzw. zwischen der Längselektrode 128 und der Längselektrode 144 erzeugt. Mit Hilfe weiterer Verknüpfungsbereiche 190, 192, zu denen Aussparungen 194 bzw. 196 führen, lassen sich elektrisch leitende Verbindungen zu weiteren zuschaltbaren Kondensatoren 116 herstellen.

Der Mäander des Hauptkondensators 112 hat eine Länge La, die größer ist als eine Länge Lb eines Mäanders des abtrennbaren Kondensators 114 bzw. eine Länge Lc eines Mäanders des zuschaltbaren Kondensators 116. Damit ist eine Kapazität C(0) des Hauptkondensators 112 größer als eine Kapazität Cm(I) des abtrennbaren Kondensators 114. Weitere Kapazitäten Cm(1) bis Cm(I-1) von weiteren abtrennbaren Kondensatoren sind gleich der Kapazität Cm(I). Eine Kapazität Cp(1) des zuschaltbaren Kondensators 116 ist gleich der Kapazität Cm(1). Kapazitäten Cp(2) bis Cp(N) der weiteren abtrennbaren Kondensatoren 116 sind gleich der Kapazität Cp(1),

Die Korrektur der Kapazität der Schaltungsanordnung 110 wird unten an Hand der Figur 5 näher erläutert.

Bei einem anderen Ausführungsbeispiel gibt es Aussparungen, die in unterschiedliche Metallisierungslagen führen, bspw. zu Verbindungs- oder Unterbrechungsmöglichkeiten, die versetzt zu darüber oder darunter liegenden Verbindungs- oder Unterbrechungsmöglichkeiten angeordnet sind. Bei einem alternativen Ausführungsbeispiel werden Verknüpfungsbereiche bzw. Bereiche für Unterbrechungen in einer oberen Metallisierungslage angeordnet, obwohl sie auch Elektroden betreffen, die in unteren Metallisierungslagen angeordnet sind. Weiterhin können die Kapazitäten Cm(1) bis Cm(I) bzw. Cp(1) bis Cp(N) der Kondensatoranordnung 110 voneinander verschiedene Kapazitäten haben.

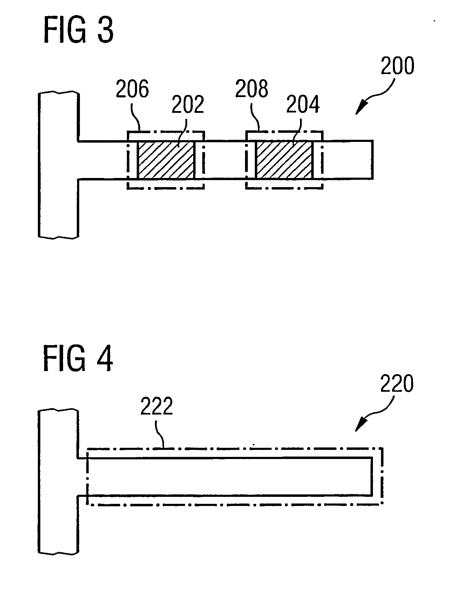

Figur 3 zeigt eine Querelektrode 200 eines Gitterkondensators. Die Querelektrode 200 hat bei etwa einem Drittel ihrer Länge einen Bereich 202 und bei etwa zwei Dritteln ihrer Länge einen Bereich 204. Zum Bereich 202 führt eine Aussparung 206. Zum Bereich 204 führt eine Aussparung 208. Bei der Korrektur der Kapazität des Gitterkondensators, zu dem die Querelektrode 200 gehört, wird entweder eine Unterbrechung im Bereich 202 oder eine Unterbrechung im Bereich 204 erzeugt. Wird die Unterbrechung im Bereich 202 erzeugt, so ist nur noch etwa ein Drittel der Querelektrode 200 schaltungstechnisch wirksam. Wird dagegen eine Unterbrechung im Bereich 204 erzeugt, so sind etwa noch zwei Drittel der Querelektrode 200 schaltungstechnisch wirksam. Durch die Auswahl eines Bereiches 202 bzw. 204 lassen sich Korrekturen der Kapazität des Gitterkondensators im Promille-Bereich ausführen.

Die Länge der Querelektrode 200 beträgt beispielsweise zehn Mikrometer. Die Breite liegt bspw. bei 0,5 Mikrometer, so dass ein Durchtrennen mit einem Laserstrahl problemlos möglich ist.

Figur 4 zeigt eine Querelektrode 220, zu der eine Aussparung 222 führt. Die Aussparung 222 erstreckt sich in etwa über die gesamte Länge der Querelektrode 220. Dadurch ist es möglich, die Querelektrode 220 an einer beliebigen Stelle zu unterbrechen. Mit anderen Worten lassen sich die Unterbrechungspunkte kontinuierlich entlang der Längsachse der Querelektrode 220 setzen.

Bei anderen Ausführungsbeispielen von Querelektroden 200 und 220 werden an Stelle oder in Kombination mit den zur Unterbrechung dienenden Bereichen Verknüpfungsbereiche verwendet. Die Unterbrechungsbereiche bzw. die Verknüpfungsbereiche werden entweder an einer Querelektrode eines Gitterkondensators oder an mehreren Querelektroden des Gitterkondensators angeordnet.

Figur 5 zeigt Verfahrensschritte zum Korrigieren der Kapazität einer integrierten Kondensatoranordnung, z.B. nach Figur 1, 2, 3 oder 4. Im Vorfeld des Verfahrens wird in einem Entwurfs- und Simulations-Stadium die Streuung der Kapazität der integrierten Schaltungsanordnung um eine Sollkapazität herum ermittelt, beispielsweise empirisch oder aufgrund von Simulationsläufen, siehe Verfahrensschritt 300. Abhängig von den Kapazitätsstreuungen werden Korrekturmöglichkeiten vorgesehen, siehe Verfahrensschritt 302. Die Korrekturmöglichkeiten sind beispielsweise abtrennbare Kondensatoren, zuschaltbare Kondensatoren, abtrennbare Kondensatorbereiche und/oder zuschaltbare Kondensatorbereiche. Die Korrekturmöglichkeiten werden im Verfahrensschritt 302 unter Berücksichtigung der zu erwartenden Kapazitätsstreuung so vorgegeben, dass im Hinblick auf die gesamte Fertigung möglichst wenig Unterbrechungen und Verknüpfungen durch Erhitzen mit dem Laserstrahl hergestellt werden müssen.

Das eigentliche Korrekturverfahren beginnt in einem Verfahrensschritt 304, an den sich die Prozessierung eines Wafers anschließt, siehe Verfahrensschritt 306. Beispielsweise werden in einem Halbleitermaterial des Wafers Transistoren erzeugt. Danach werden Metallisierungslagen aufgebracht, wobei auch Kondensatoren erzeugt werden.

In einem Verfahrensschritt 308 wird über eine Messung die Ist-Kapazität einer integrierten Kondensatoranordnung erfasst, d.h. insbesondere die Kapazität des Hauptkondensators 12, 112 zusammen mit den Kapazitäten der abtrennbaren Kondensatoren 14, 114.

In einem folgenden Verfahrensschritt 310 wird die Ist-Kapazität mit der Soll-Kapazität verglichen. Ist die Ist-Kapazität kleiner oder größer als die Soll-Kapazität, insbesondere kleiner oder größer als ein vorgegebener Toleranzbereich, so folgt unmittelbar nach dem Verfahrensschritt 310 ein Verfahrensschritt 312. Im Verfahrensschritt 312 wird geprüft, ob die Ist-Kapazität größer als die Soll-Kapazität ist. Ist dies der Fall, so folgt nach dem Verfahrensschritt 312 ein Verfahrensschritt 314, in welchem mit Hilfe eines Laserstrahls Unterbrechungen in der integrierten Kondensatoranordnung erzeugt werden, wobei abtrennbare Kondensatoren 14, 114 vom Hauptkondensator 12, 112 abgetrennt werden. Die Kapazität der Kondensatoranordnung wird kleiner. Auch ein Abtrennen eines Elektrodenabschnitts von einer Querelektrode wird alternativ durchgeführt.

Wird dagegen im Verfahrensschritt 312 festgestellt, dass die Ist-Kapazität kleiner als die Soll-Kapazität ist, so folgt nach dem Verfahrensschritt 312 unmittelbar ein Verfahrensschritt 316. Im Verfahrensschritt 316 werden Verknüpfungsbereiche mit Hilfe eines Laserstrahls erhitzt. Dadurch werden zuschaltbare Kondensatoren 16, 116 zum Hauptkondensator 12, 112 bzw. zu einem Hauptbereich hinzugeschaltet. Somit vergrößert sich die Kapazität der Kondensatoranordnung in Richtung der Soll-Kapazität. Auch ein Zuschalten von Elektrodenabschnitten einer Querelektrode wird alternativ durchgeführt.

Wird im Verfahrensschritt 310 dagegen festgestellt, dass Ist-Kapazität und Soll-Kapazität übereinstimmen, so folgt unmittelbar ein Verfahrensschritt 318. Der Verfahrensschritt 318 wird auch nach dem Verfahrensschritt 314 oder dem Verfahrensschritt 316 ausgeführt. Im Verfahrensschritt 318 wird der Wafer weiter prozessiert. Dabei wird unter anderem eine Passivierungsschicht aufgebracht, welche die Aussparungen für den Laserstrahl verschließt.

In einem weiteren Verfahrensschritt 320 werden die auf dem Wafer angeordneten Schaltkreise vereinzelt und in Gehäuse eingegossen. Das Verfahren wird in einem Verfahrensschritt 322 beendet.

Bei einem anderen Ausführungsbeispiel wird die Korrektur nach dem Vereinzeln der Schaltkreise durchgeführt. Beispielsweise werden Stromstöße zum Erhitzen der Unterbrechungsbereiche bzw. der Verknüpfungsbereiche genutzt. Auch die Abfragen in den Verfahrensschritten 310 und 312 lassen sich anders formulieren.

Durch das angegebene Verfahren ergeben sich die folgenden Vorteile:

- die durch Geometrie- oder Prozessschwankungen verursachten Streuungen der Kapazitäten lassen sich auf einfache Weise nachträglich korrigieren. Damit kann die Ausbeute bzw. die Performance erhöht werden.
- Die Möglichkeit der nachträglichen Korrektur erlaubt darüber hinaus ein für den jeweiligen integrierten Schaltkreis individuelles Anpassen der Kapazität. Damit kann eine speziell auf andere Schaltungselemente abgestimmte Kapazitätsanpassung vorgenommen werden, z.B. zur optimalen Arbeitspunkteinstellung. Dies ist insbesondere dann vorteilhaft, wenn die anderen Schaltungselemente nicht mehr korrigierbar sind.

Durch Abtrennen bzw. Hinzufügen von Bereichen des Kondensators mit Hilfe von sogenannten Fuses bzw. Antifuses lässt sich also der Einfluss von Prozess- und Geometrieschwankungen auf die Parameter des Hauptkondensators, insbesondere auf die Kapazität und auf den Widerstand (und damit auf die RC-Konstante), nachträglich korrigieren.

Bei der Korrektur in den Verfahrensschritten 310 bis 316 lässt sich die folgende Formel verwenden:

$$\text{Ckorr} = \text{C(0)} - \text{Summe}(i=1 \text{ bis } I1 \text{ über } \text{Cm}(i)) + \text{Summe}(n=1 \text{ bis } N1 \text{ über } \text{Cp}(n)),$$

wobei die verwendeten Größen bis auf die Größen I1 und N1 bereits oben erläutert worden sind. Der Index i bei Summierung über die Kapazitäten Cm muss alle abgetrennten Kondensatoren berücksichtigen, wobei I1 den letzten abgetrennten Kondensator bezeichnet. Der Index bei der Summierung über die Kapazitäten Cp muss alle zugeschalteten Kapazitäten berücksichtigen, wobei N1 den letzten zugeschalteten Kondensator bezeichnet. Weiterhin ist zu beachten, das entweder Kondensatoren zugeschaltet oder abgetrennt werden.

Sind die Kapazitäten Cm bzw. Cp gleich, so kann an Stelle der Summe mit einem Faktor multipliziert werden, der die Anzahl der abgetrennten bzw. der zugeschalteten Kondensatoren angibt.

Beim Ermitteln der Kapazitätsstreuung lassen sich die folgenden für einen Plattenkondensator geltenden Zusammenhänge nutzen:

$$C = \varepsilon 0 \cdot \varepsilon r \cdot Aeff / Deff,$$

wobei ε0, εr die entsprechenden Dielektrizitätskonstanten, Aeff die effektive Elektrodenfläche und Deff den effektiven Elektrodenabstand darstellen. Eine Schwankung der Fläche ΔAeff bzw. des Abstandes ΔDeff bedingt dann eine Änderung der Kapazität von:

$$\Delta C = \Delta Aeff / Aeff \ bzw. \ \Delta C = \Delta Deff / Deff.$$

In erster Näherung entspricht die effektive Elektrodenfläche bei:

a) den MIM-Kondensatoren: der überlappenden Fläche der Elektroden,
b) den Sandwich-Kondensatoren: der Fläche der Metallelektroden,
c) den Gitterkondensatoren: der Seitenfläche der Leiterbahnen, die sich aus der Länge L und der Dicke T ergibt.

Der effektive Elektrodenabstand entspricht bei:

a) den MIM-Kondensatoren: der Dicke des Dielektrikums, das sich vom Dielektrikum zwischen den Metallisierungslagen unterscheidet,
b) den Sandwich-Kondensatoren: der Dicke des Intermetall-Dielektrikums,
c) den Gitterkondensatoren: der Dicke des Intrametall-Dielektrikums, d.h. des sogenannten Spacings.

Ein anderer Einflussfaktor ist bspw. bei Gitterkondensatoren die Ausbildung von Ecken. Diese Einflussgrößen lassen sich zumindest messtechnisch erfassen und dann berücksichtigen.

Die Schwankungen der Kapazitäten können folgende prozessbedingte Ursachen haben:

a) MIM-Kondensatoren: Schwankungen in der Dicke des MIM-Dielektrikums, z.B. durch inhomogene Abscheideraten über dem Wafer oder unterschiedliche Rauhigkeit der unteren Elektrode. b) Sandwich-Kondensatoren: Schwankungen der Dicke des Intermetall-Dielektrikums, z.B. Dickeschwankungen durch Polier-Inhomogenitäten oder Schwankungen der Ätztiefe über dem Wafer.
c) Gitterkondensatoren: Schwankungen des Elektrodenabstandes durch Variation der Dicke des Intrametall-Dielektrikums bedingt z.B. durch Lithografieschwankungen, RIE-Strukturierung (Reactive Ion Etching) bei Verwendung von Aluminium oder durch Grabenätzen bei Verwendung von Kupfer. Weitere Ursachen sind Schwankungen der Elektrodenfläche durch Variation der Leitbahndicke bzw. durch CMP-Schwankungen (Chemical Mechanical Polishing), sogenanntes Dishing, nicht rechtwinkliges Trenchprofil bei Verwendung von Kupfer oder durch inhomogene Abscheideraten.
Bei MIM-Kondensatoren und Sandwich-Kondensatoren wird die Kapazität durch direktes Abtrennen bzw. Zuschalten von M Flächensegmenten der Elektrode korrigiert:

$$A = A0 \pm Summe(i=1 \ bis \ M \ über \ Ai),$$

dabei sind A0 die nicht mehr korrigierbare Elektrodengrundfläche, M eine natürliche Zahl und Ai die abtrennbaren bzw. zuschaltbaren diskreten Flächenelemente. Für die abtrennbaren Flächenelemente gilt das Minuszeichen. Für die zuschaltbaren Flächenelemente gilt das Pluszeichen.
Bei den Gitterkondensatoren wird die Elektrodenfläche A über die Länge L der Leitbahn eingestellt: A = L - T, wobei T die mittlere Leitbahndicke innerhalb der Kondensatorstruktur ist. Durch Abtrennen bzw. Zuschalten von M Leitbahnsegmenten, z.B. n diskreten Segmenten Li der Elektrode wird korrigiert:

$$L = L0 \pm Summe(i=1 \text{ bis } M \text{ über } Li),$$

wobei L0 die nicht mehr korrigierbare Elektrodengrundlänge, M eine natürliche Zahl und Li die abtrennbaren bzw. zuschaltbaren diskreten Leitbahnsegmente bezeichnen. Für die abtrennbaren Leitbahnsegmente gilt das Minuszeichen. Für die zuschaltbaren Leitbahnsegmente gilt das Pluszeichen.

**Patentansprüche**

1. Satz integrierter Kondensatoranordnungen (10),
   mit mindestens zwei integrierten Kondensatoranordnungen (10), die gemäß gleichen geometrischen Entwürfen hergestellt worden sind und die jeweils einen schaltungstechnisch wirksamen Hauptkondensator (12) und mindestens einen Korrekturkondensator (16) enthalten,
   **gekennzeichnet durch**:

   eine elektrisch leitfähigen Antifuse-Verbindung zwischen dem Korrekturkondensator und dem Hauptkondensator in der einen Kondensatoranordnung, wobei die Verbindung nach der Herstellung des Hauptkondensators dieser Kondensatoranordnung hergestellt worden ist,
   eine elektrisch isolierende Antifuse-Unterbrechung (62) zwischen dem gleichen Korrekturkondensator (16) und dem Hauptkondensator (12) in der anderen Kondensatoranordnung (10), wobei die Unterbrechung gemäß den geometrischen Entwürfen hergestellt worden ist,
   jeweils mindestens einen weiteren Korrekturkondensator (14) je Kondensatoranordnung,
   eine elektrisch leitfähige Fuse-Verbindung (42) zwischen dem weiteren Korrekturkondensator und dem Hauptkondensator (12) in der einen Kondensatoranordnung (10), wobei die Verbindung gemäß den geometrischen Entwürfen hergestellt worden ist,
   und **durch** eine elektrisch isolierenden Fuse-Unterbrechung zwischen dem gleichen weiteren Korrekturkondensator und dem Hauptkondensator in der anderen Kondensatoranordnung, wobei die Unterbrechung nach der Herstellung des Hauptkondensators der anderen Kondensatoranordnung hergestellt worden ist.

2. Kondensatoranordnungen (10) nach Anspruch 1 , **dadurch gekennzeichnet, dass** die Verbindung und die Unterbrechung an gleichen Positionen in den Kondensatoranordnungen (10) liegen.

3. Kondensatoranordnungen (10) nach Anspruch 1 oder 2, **dadurch gekennzeichnet, dass** die Verbindung durch lokales Erhitzen erzeugt worden ist,
   und/oder dass die Verbindung eine ein Dielektrikum durchdringende Materialverwerfung enthält, die infolge des Erhitzens entstanden ist.

4. Kondensatoranordnungen (10) nach einem der vorhergehenden Ansprüche, **dadurch gekennzeichnet, dass** ein die Verbindung bedeckendes Material eine Aussparung enthält, die zur Verbindung führt,
   dass ein die Unterbrechung (62) bedeckendes Material eine Aussparung (58) enthält, die zu der Unterbrechung führt,
   und/oder dass die Aussparungen mit einem passivierenden Material gefüllt sind.

5. Kondensatoranordnungen (10) nach Anspruch 1, **dadurch gekennzeichnet, dass** die weitere Unterbrechung durch lokales Erhitzen und Verdampfen eines elektrisch leitenden Abschnitts entstanden ist.

6. Kondensatoranordnungen (110) nach einem der vorhergehenden Ansprüche, **dadurch gekennzeichnet, dass** Dielektrika der Kondensatoren (112 bis 116) eine Dicke haben, die gleich der Dicke eines Dielektrikums zwischen Metallisierungslagen ist, in denen Verbindungsabschnitte von Verbindungen zu integrierten Halbleiterbauelementen liegen.

7. Kondensatoranordnungen (110) nach einem der vorhergehenden Ansprüche, **dadurch gekennzeichnet, dass** die Kondensatoren (112 bis 116) Elektroden haben, die in mehr als zwei Metallisierungslagen liegen,
   und/oder dass die Elektroden vollflächig oder gitterartig ausgebildet sind.

8. Kondensatoranordnungen (10) nach einem der vorhergehenden Ansprüche, **dadurch gekennzeichnet, dass** Dielektrika der Kondensatoren (12 bis 16) eine Dicke haben, die kleiner als die Dicke des Dielektrikums zwischen Metallisierungslagen ist, in denen Verbindungsabschnitte von Verbindungen zu integrierten Halbleiterbauelementen liegen, vorzugsweise mindestens um die Hälfte kleiner.

9. Kondensatoranordnungen (10, 110) nach einem der vorhergehenden Ansprüche, **dadurch gekennzeichnet, dass** die Kapazität eines Korrekturkondensators (14, 16; 114, 116) weniger als 1/3, weniger als 1/10, weniger als 1/100 oder weniger als 1/1000 der Kapazität des Hauptkondensators (12, 112) beträgt.

**Claims**

1. Set of integrated capacitor arrangements (10),
   having at least two integrated capacitor arrangements (10), which have been produced in accordance with identical geometrical designs and which each contain a circuitry-effective main capacitor (12) and at least one correction capacitor (16),
   **characterized by**
   an electrically conductive anti-fuse connection between the correction capacitor and the main capacitor in one capacitor arrangement, the connection having been produced after the production of the main capacitor of this capacitor arrangement,
   an electrically insulating anti-fuse interruption (62) between the same correction capacitor (16) and the main capacitor (12) in the other capacitor arrangement (10), the interruption having been produced in accordance with the geometrical designs,
   in each case at least one further correction capacitor (14) per capacitor arrangement,
   an electrically conductive fuse connection (42) between the further correction capacitor and the main capacitor (12) in one capacitor arrangement (10), the connection having been produced in accordance with the geometrical designs,
   and by an electrically insulating fuse interruption between the same further correction capacitor and the main capacitor in the other capacitor arrangement, the interruption having been produced after the production of the main capacitor of the other capacitor arrangement.

2. Capacitor arrangements (10) according to Claim 1, **characterized in that** the connection and the interruption are situated at identical positions in the capacitor arrangements (10).

3. Capacitor arrangements (10) according to Claim 1 or 2, **characterized in that** the connection has been produced by local heating,
   and/or **characterized in that** the connection contains a material warpage which penetrates through a dielectric and arose on account of the heating.

4. Capacitor arrangements (10) according to one of the preceding claims, **characterized in that** a material covering the connection contains a cutout leading to the connection,
   **characterized in that** a material covering the interruption (62) contains a cutout (58) leading to the interruption,
   and/or **characterized in that** the cutouts are filled with a passivating material.

5. Capacitor arrangements (10) according to Claim 1, **characterized in that** the further interruption arose as a result of local heating and vaporization of an electrically conducting section.

6. Capacitor arrangements (110) according to one of the preceding claims, **characterized in that** dielectrics of the capacitors (112 to 116) have a thickness which is equal to the thickness of a dielectric between metallization layers in which connection sections of connections to integrated semiconductor components are situated.

7. Capacitor arrangements (110) according to one of the preceding claims, **characterized in that** the capacitors (112 to 116) have electrodes situated in more than two metallization layers,
   and/or **characterized in that** the electrodes are formed in a whole-area or grid-like manner.

8. Capacitor arrangements (10) according to one of the preceding claims, **characterized in that** dielectrics of the capacitors (12 to 16) have a thickness which is less than the thickness of the dielectric between metallization layers in which connection sections of connections to integrated semiconductor components are situated, preferably less at least by half.

9. Capacitor arrangements (10, 110) according to one of the preceding claims, **characterized in that** the capacitance of a correction capacitor (14, 16; 114, 116) amounts to less than 1/3, less than 1/10, less than 1/100 or less than 1/1000 of the capacitance of the main capacitor (12, 112).

**Revendications**

1.  Ensemble de dispositifs intégrés de condensateurs (10) comportant au moins deux dispositifs intégrés de condensateurs (10) qui ont été fabriqués suivant des topologies géométriques semblables et qui comprennent chacun un condensateur principal (12) efficace en technique des circuits et au moins un condensateur de correction (16), **caractérisé par**

    - une liaison antifusible électroconductrice entre le condensateur de correction et le condensateur principal dans l'un des dispositifs de condensateurs, la liaison ayant été produite après que le condensateur principal de ce dispositif de condensateurs a été fabriqué,
    - une interruption antifusible (62) électriquement isolante entre le même condensateur de correction (16) et le condensateur principal (12) dans l'autre dispositif de condensateurs (10), l'interruption ayant été produite suivant les topologies géométriques,
    - au moins un autre condensateur de correction (14) respectivement pour chaque dispositif de condensateurs,
    - une liaison fusible (42) électroconductrice entre l'autre condensateur de correction et le condensateur principal (12) dans l'un des dispositifs de condensateurs (10), la liaison ayant été produite suivant les topologies géométriques
    - et une interruption antifusible électriquement isolante entre l'autre condensateur de correction identique et le condensateur principal dans l'autre dispositif de condensateurs, l'interruption ayant été produite après que le condensateur principal de l'autre dispositif de condensateurs a été fabriqué.

2.  Dispositif de condensateurs (10) selon la revendication 1, **caractérisé en ce que** la liaison et l'interruption se trouvent à des emplacements identiques dans les dispositifs de condensateurs (10).

3.  Dispositif de condensateurs (10) selon la revendication 1 ou 2, **caractérisé en ce que** la liaison a été produite par chauffage local et/ou que la liaison comporte un gauchissement de matériau qui traverse un diélectrique et qui est en raison du chauffage.

4.  Dispositif de condensateurs (10) selon l'une des revendications précédentes, **caractérisé en ce qu'**un matériau qui recouvre la liaison comporte un creux qui mène à la liaison,
    qu'un matériau recouvrant l'interruption (62) comprend un creux (58) qui mène à l'interruption
    et/ou que les creux sont remplis d'un matériau passivant.

5.  Dispositif de condensateurs (10) selon la revendication 1, **caractérisé en ce que** l'autre interruption a été obtenue par chauffage local et par évaporation d'un segment électroconducteur.

6.  Dispositif de condensateurs (110) selon l'une des revendications précédentes, **caractérisé en ce que** les condensateurs (112 à 116) ont des diélectriques dont l'épaisseur est égale à l'épaisseur d'un diélectrique entre des couches métallisées dans lesquelles se trouvent des segments de liaison vers des éléments intégrés à semi-conducteurs.

7.  Dispositif de condensateurs (110) selon l'une des revendications précédentes, **caractérisé en ce que** les condensateurs (112 à 116) ont des électrodes qui se trouvent dans plus de deux couches métallisées
    et/ou que les électrodes sont une surface pleine ou ont une forme de grille.

8.  Dispositif de condensateurs (10) selon l'une des revendications précédentes, **caractérisé en ce que** les condensateurs (12 à 16) ont des diélectriques dont l'épaisseur est inférieure à l'épaisseur du diélectrique entre des couches métallisées dans lesquelles se trouvent des segments de liaison pour des liaisons vers des éléments intégrés à semi-conducteurs, de préférence plus petites d'au moins la moitié.

9.  Dispositif de condensateurs (10, 110) selon l'une des revendications précédentes, **caractérisé en ce que** la capacité d'un condensateur de correction (14, 16 ; 114, 116) a une capacité inférieure à 1/3, inférieure à 1/10, inférieure à 1/100 ou inférieure à 1/1 000 de la capacité du condensateur principal (12, 112).

FIG 1

FIG 2

## FIG 3

206 202 208 204 200

## FIG 4

222 220

## FIG 5

Ermitteln der Kapazitätsstreuung um Sollkapazität — 300

z.B. empirisch

Entwurf und Simulation

Korrekturmöglichkeiten vorsehen — 302

Start — 304

Scheibenprozessierung — 306

Erfassen der Ist-Kapazität — 308

Ist = Soll? — 310

nein

ja

Ist > Soll? — 312

ja

nein

314 — Unterbrechung

Verknüpfung — 316

Passivieren — 318

Vereinzeln — 320

Ende — 322